# EUROPEAN PATENT APPLICATION

(11) **EP 1 193 813 A1**
(43) Date of publication of application: **03.04.2002**
(21) Application number: 01921979.9
(22) Date of filing: 23.04.2001
(51) Int. Cl.: H01S 3/0941, H01S 5/024

(54) **COOLING BLOCK, LD DEVICE WITH THE COOLING BLOCK, AND SOLID LASER DEVICE USING THE LD DEVICE AS EXCITATION LIGHT SOURCE**

(30) Priority: 26.04.2000 JP 2000125495
(71) Applicant: Mitsubishi Heavy Industries, Ltd., Tokyo 100-8315 (JP)
(72) Inventor: NODA, Osamu, MITSUBISHI HEAVY INDUSTRIES, LTD., Takasago-shi, Hyogo 676-8686 (JP); NAGASAWA, Yasushi, MITSUBISHI HEAVY INUSTRIES LTD., Takasago-shi, Hyogo 676-8686 (JP); HIRAI, Syozo, MITSIBISHI HEAVY INDUSTRIES, LTD., Takasago-shi, Hyogo 676-8686 (JP); WATANABE, Masaharu, MITSUBISHI HEAVY INDUS., LTD., Takasago-shi, Hyogo 676-8686 (JP); AKABA, Takashi, MITSUBISHI HEAVY INDUSTRIES, LTD., Kobe-shi, Hyogo 652-8585 (JP)
(74) Representative: HOFFMANN - EITLE
(86) International application number: JP0103431
(87) International publication number: WO0182424

(57) **Abstract**

A cooling block 17 has three water channels 21 formed so as to be located near an LD device 18 fixed to a side surface 17c, each water channel 21 having a water channel sectional shape like an elongated hole, and being inclined relative to the side surface 17c. Heat generated by the LD device 18 is eliminated by cooling water flowing through the water channels 21. The water channel sectional area of an inlet manifold water channel is rendered not less than twice the water channel sectional area of the cooling block water channel. Irregularities are formed on the inner surface of each of the cooling block water channels. Further, an inlet portion of the cooling block water channel is chamfered or given a curvature.

## Description

### Technical Field

This invention relates to a cooling block, an LD apparatus having the cooling blocks, and a solid state laser apparatus having the LD apparatus as an exciting light source.

### Background Art

A semiconductor laser (laser diode; may hereinbelow be referred to as LD) apparatus attracts attention as an exciting light source of a solid state laser apparatus such as a YAG laser. As is well known, this LD apparatus generates laser light from an LD device by flowing an electric current through the LD device, and is excellent in oscillation efficiency, etc. as compared with a conventional pumping lamp.

Of importance to the LD apparatus is how efficiently the heat generation of the LD device should be eliminated. That is, the electrooptical conversion efficiency of the LD device is, for example, about 50%. In this case, nearly half of an electric power supplied to the LD device turns into heat. When heat builds up in the LD device, a decrease in the oscillation efficiency is induced. Thus, heat elimination of the LD device has generally been performed by Peltier device. However, this method of heat elimination cannot permit frequently repeated oscillation.

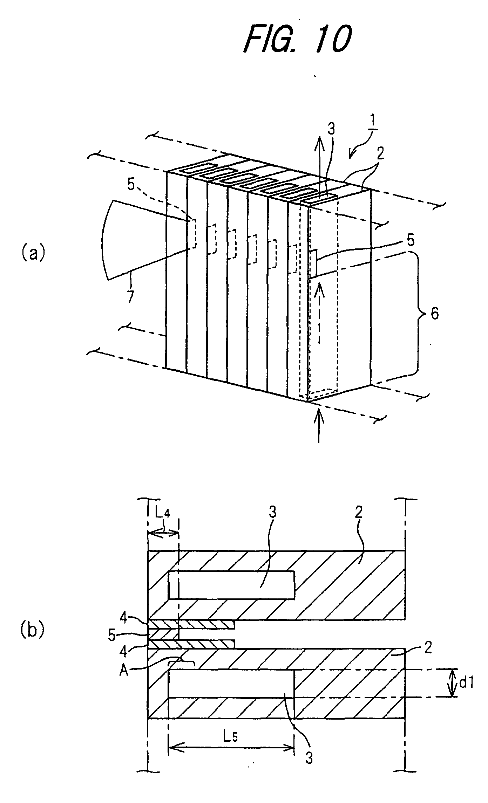

The inventors of the present invention, therefore, have proposed an LD apparatus, as shown in FIGS. 10(a) and 10(b), in Japanese Unexamined Patent Publication No. 1999-340549. FIG. 10(a) is a perspective view showing a schematic configuration of a conventional LD apparatus. FIG. 10(b) is an enlarged cross sectional view of the LD apparatus.

As shown in these drawings, an LD apparatus 1 comprises a stack of many cooling blocks (microchannels) 2. An LD device 5 is provided between the adjacent cooling blocks 2 via indium sheets 4. The LD device 5 used here comprises several tens of active media arranged one-dimensionally (i.e., a one-dimensional LD array device), each of the active media having a cross sectional area of several micrometers × several hundred micrometers. By flowing a drive current in the stack direction of the cooling blocks 2 by a power source device (not shown), laser light 7 is emitted from the respective LD devices 5.

A water channel 3 is formed in each of the cooling blocks 2. The cooling block water channel 3 is formed such that its water channel section (cross section) is rectangular, and its longitudinal direction is parallel to the side surface of the cooling block 3. By flowing cooling water through the cooling block water channel 3, heat generation of the LD device 5 is eliminated. An approach zone 6 with a length of 40 d₁ (e.g., 40 mm) relative to the width d₁ (e.g., 1 mm) of the water channel section is provided in the cooling block water channel 3. Because of this structure, the flowing state of cooling water, which has flowed into the cooling block water channel 3, stabilizes by the time it arrives at the position of installation of the LD device 5.

Since the LD apparatus 1 has a high capacity to eliminate heat generation of the LD device 5, it can endure frequently repeated oscillation.

However, the above-described conventional LD apparatus 1 permits frequently repeated oscillation, but cannot meet continuous wave oscillation of a high output (e.g., 60W), because the amount of heat generation of the LD device 5 is too great.

In detail, the area of heat generation of the LD device 5 is as tiny as 1 mm (width of the device) by 10 mm (length of the device), as shown in FIG. 10(b). Thus, a portion (A in the drawing) of the cooling block water channel 3 effectively acts to eliminate the heat of the LD device 5. Consequently, the conventional cooling block 2 needs a large flow rate of cooling water. Moreover, a heat flux on the water channel surface near the LD device is great (because the area of heat transfer is small). Hence, the cooling block 2 has a low cooling capacity and is unsuitable for a high output/continuous wave oscillation LD apparatus.

Furthermore, the approach zone 6 needs to be provided in the cooling block water channel 3, thus making the conventional cooling block 2 that long. That is, the width L₄ of the LD device 5 is as small as 10 mm, while the length L₅ of the cooling block 5 is as large as 70 mm. For this reason, the conventional cooling block 2 has not been suitable for forming a tiny water channel section, in terms of processability and channel resistance.

Thus, the present invention has been accomplished in light of the foregoing problems. The object of the invention is to provide a cooling block having a high capacity to eliminate heat, applicable to a high output/continuous wave oscillation LD apparatus, and so small in dimensions as to be suitable for forming a tiny water channel section; an LD apparatus having the cooling blocks; and a solid state laser apparatus having the LD apparatus as an exciting light source.

### Disclosure of the Invention

A cooling block, which attains the above object, is characterized by the following features:
1) A plurality of refrigerant channels are formed so as to be located near an LD device fixed to the side surface of the cooling block, and heat generated by the LD device is eliminated by a refrigerant flowing through the refrigerant channels.
   According to this invention, the water channel surface (heat transfer area) close to the LD device markedly increases compared with the earlier technologies, resulting in a decreased heat flux. Thus, the cooling block can be applied as a heat sink for a high output/continuous wave oscillation LD apparatus.
2) In the cooling block described in 1),
   the plurality of refrigerant channels each have a channel sectional shape like an elongated hole, and are inclined relative to the side surface.
   According to this invention, a sufficient heat transfer area can be secured, and the pressure loss coefficient can be decreased, and the width of the cooling block can be limited to a predetermined value. Hence, when many of the cooling blocks, each having the LD device fixed thereto, are stacked to constitute an LD apparatus, the LD devices can be integrated at a high density, and the apparatus can be downsized.
3) In the cooling block described in 1) or 2),
   irregularities are formed on the inner surface of each of the refrigerant channels.
   According to this invention, the heat transfer area can be further increased and the heat flux can be decreased, thus further increasing the heat elimination capacity.
4) In the cooling block described in 1), 2) or 3),
   the channel sectional area of an inlet manifold attached to the inlet side of the refrigerant channel is rendered not less than twice the channel sectional area of the refrigerant channel.
   According to this invention, changes in the velocity of cooling water flowing through the cooling block water channel can be described. Thus, the conventional approach zone is unnecessary for the cooling block water channel. As a result, the cooling block can be made much shorter than the conventional cooling block. Hence, the cooling block is suitable for making the water channel section tiny, and contributes to downsizing of the apparatus.
5) In the cooling block described in 1), 2), 3) or 4),
   an inlet portion of the refrigerant channel is chamfered or given a curvature.
   According to this invention, the pressure loss coefficient of cooling water can be reduced. Thus, it is possible to obtain the desired amount (flow velocity) of cooling water easily, and curtail an increase in pressure loss due to an abrupt reduction of the water channel sectional area between the inlet manifold water channel and the cooling block water channel.
   The configuration of an LD apparatus according to the present invention is characterized by the following features:
6) The LD apparatus comprises the cooling block described in 1), 2), 3), 4) or 5) having the LD device fixed to the side surface of the cooling block.
   This invention is a high performance apparatus excellent in oscillation efficiency.
7) The LD device is fixed to the side surface of the cooling block described in 1), 2), 3), 4) or 5), and a plurality of the cooling blocks are stacked to constitute the LD apparatus.
   This invention is a high performance apparatus excellent in oscillation efficiency, small in size, and capable of high output/continuous wave oscillation.
   The configuration of a laser apparatus according to the present invention is characterized by the following features:
8) The LD apparatus described in 6) or 7) is provided as an exciting light source, and laser light emitted from the LD apparatus is directed at a solid crystal.

This invention is a high performance apparatus compact and capable of high output/continuous wave oscillation.

### Brief Description of the Drawings

FIG. 1 is a schematic configuration drawing of a YAG laser apparatus according to an embodiment of the present invention.
FIG. 2(a) is a configuration drawing of one cooling channel of an LD apparatus according to the embodiment of the present invention, and FIG. 2(b) is a view taken in the direction of B in FIG. 2(a).
FIGS. 3(a) and 3(b) are structural drawings of an inlet side and an outlet side of a water channel of a cooling block constituting the cooling channel.
FIG. 4(a) is an enlarged sectional view taken on line C-C of FIG. 2(a), and FIG. 4(b) is an enlarged view of a portion D in FIG. 4(a).
FIG. 5 is a sectional view showing another example of the water channel sectional shape of the cooling block water channel.
FIG. 6 is a sectional view showing still another example of the water channel sectional shape of the cooling block water channel.
FIG. 7 is a sectional view showing a further example of the water channel sectional shape of the cooling block water channel.
FIG. 8 is a sectional view showing a still further example of the water channel sectional shape of the cooling block water channel.
FIG. 9 is a configuration drawing of the LD apparatus.
FIG. 10(a) is a perspective view showing a schematic configuration of a conventional LD apparatus, and FIG. 10(b) is an enlarged cross sectional view of the LD apparatus.

### Best Mode for Carrying Out the Invention

An embodiment of the present invention will be described in detail with reference to the accompanying drawings.

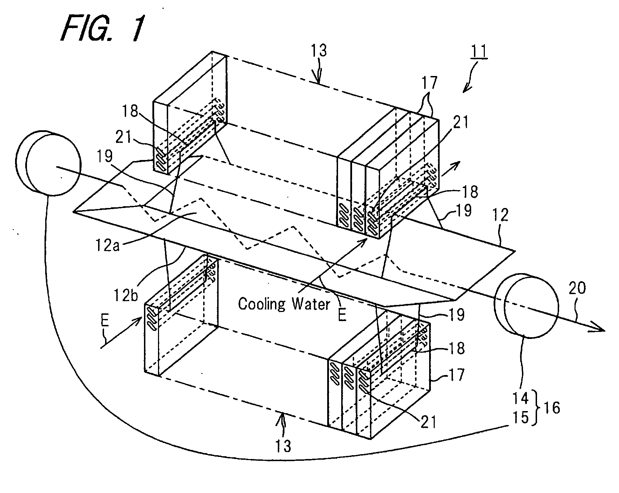

FIG. 1 is a schematic configuration drawing of a YAG laser apparatus according to the embodiment of the present invention. As shown in the drawing, a YAG laser apparatus 11, which is a solid state laser apparatus, has a slab-shaped YAG crystal 12, which is a solid crystal, LD apparatuses 13, which are an exciting light source, and a resonator 16 composed of an output mirror 14 and a total reflection mirror 15 arranged on both sides in the longitudinal direction of the slab-shaped YAG crystal 12. The two LD apparatuses 13 are disposed so as to be opposed to both side surfaces 12a and 12b of the slab-shaped YAG crystal 12.

The LD apparatus 13 comprises a stack of many cooling blocks (microchannels) 17, and each of the cooling blocks 17 has an LD device 18 fixed thereto (details will be offered later on). The LD device 18 used here comprises several tens of active media arranged one-dimensionally (i.e., a one-dimensional LD array device), each of the active media having a cross sectional area of several micrometers by several hundred micrometers. The LD device 18 is of the following size: length x width x thickness = 10 mm x 1 mm × 0.13 mm. The LD devices 18 are stacked, together with the cooling blocks 17, to constitute a two-dimensional LD array device. By flowing a drive electric current in the stack direction of the cooling blocks 17 by a power source device (not shown), laser light 19 is emitted from the respective LD devices 18.

The laser light 19 emitted from the LD apparatuses 13 is directed at the opposite side surfaces 12a and 12b of the slab-shaped YAG crystal 12 to excite a laser medium doped into the slab-shaped YAG crystal. Light generated thereby propagates in a zigzag within the slab-shaped YAG crystal, and is reflected by the output mirror 14 and the total reflection mirror 15 of the resonator 16. As a result, YAG laser light 20 is delivered from the output mirror.

Heat generation of the LD device 18 occurring on this occasion is eliminated by flowing cooling water (pure water), as indicated by arrows E, through water channels 21 of an elongated hole/inclined type formed in the respective cooling blocks 17 (details will be offered later on).

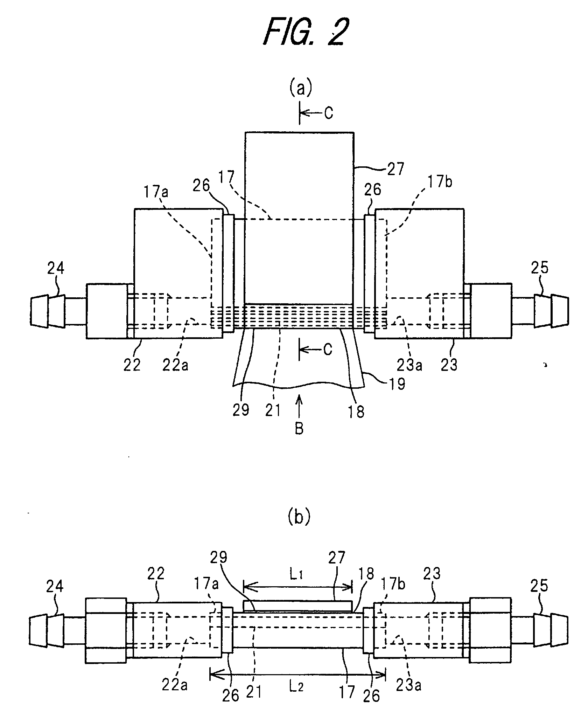

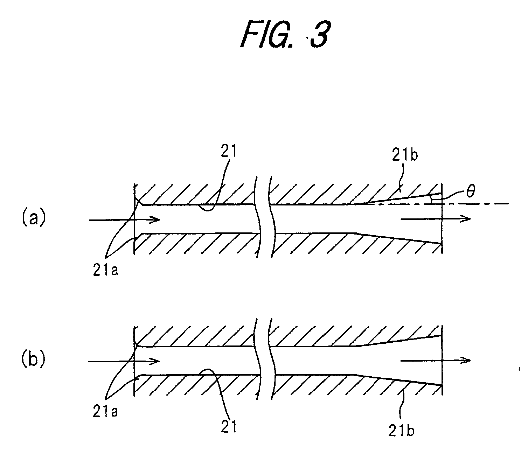

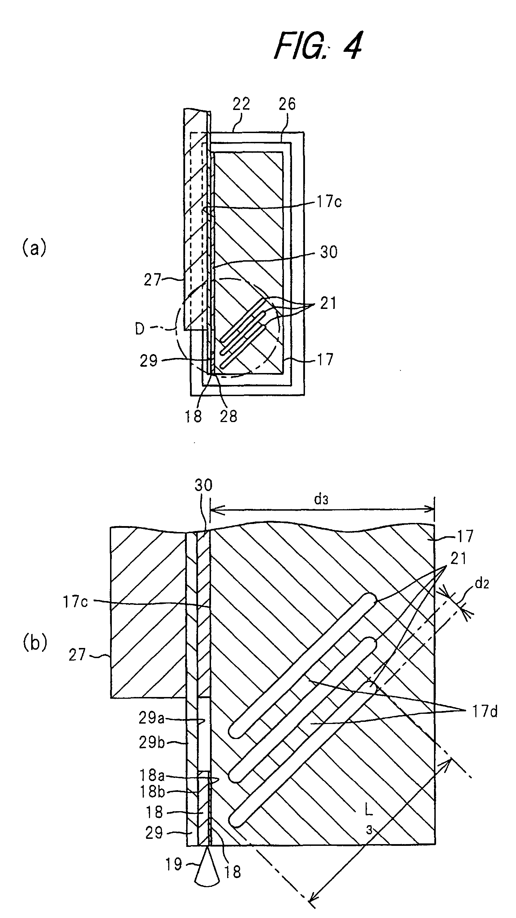

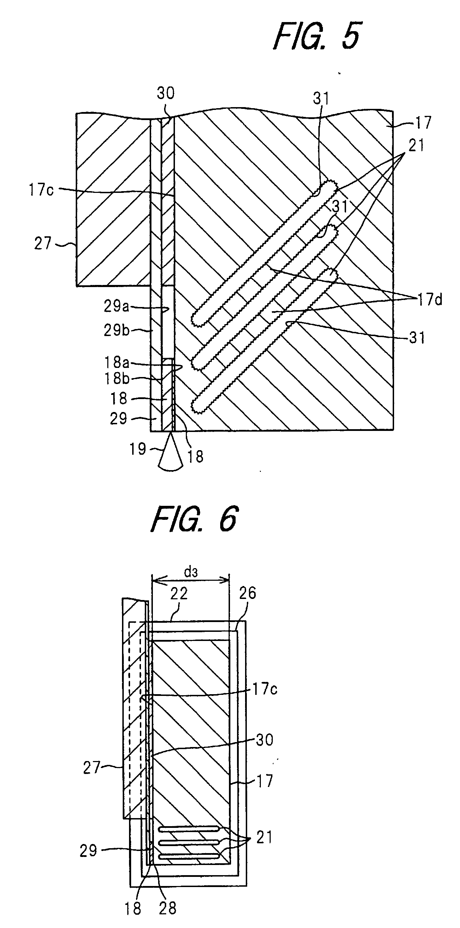

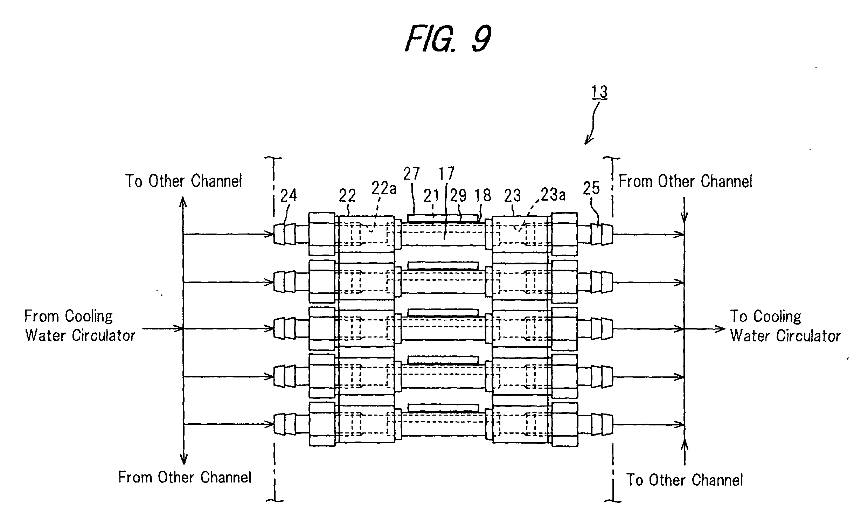

The configuration of the LD apparatus 13 will be described in detail with reference to FIGS. 2(a), 2(b) to FIG. 9. FIG. 2(a) is a configuration drawing of one cooling channel of an LD apparatus according to the embodiment of the present invention. FIG. 2(b) is a view taken in the direction of B in FIG. 2(a). FIGS. 3(a) and 3(b) are structural drawings of the inlet side and the outlet side of a water channel of a cooling block constituting the cooling channel. FIG. 4(a) is an enlarged sectional view taken on line C-C of FIG. 2(a). FIG. 4(b) is an enlarged view of a portion D in FIG. 4(a). FIGS. 5, 6, 7 and 8 are sectional views showing other examples of the water channel sectional shape of the cooling block water channel. FIG. 9 is a configuration drawing of the LD apparatus.

An explanation for the configuration of one cooling channel is offered. As shown in FIGS. 2(a) and 2(b), an electrode plate 27 is attached to the cooling block 17, and the LD device 18 is interposed between the electrode plate 27 and the cooling block 17 (details to be offered later on). Flanges 26 are formed near both ends of the cooling block 17, and an inlet manifold 22 and an outlet manifold 23 are fitted over opposite end portions 17a and 17b of the cooling block 17 so as to contact these flanges 26. The fitting portions are brazed over the entire periphery to prevent leakage of cooling water completely. The brazing is performed for the many cooling blocks 17 at a time by the vacuum brazing method. That is, a multiplicity (e.g., 50) of the cooling blocks 17, each fitted with the inlet and outlet manifolds 22 and 23 at the opposite end portions 17a and 17b, are placed in a vacuum furnace, and simultaneously brazed. By this procedure, the operating time can be markedly shortened in comparison with soldering of the inlet and outlet manifolds 22 and 23 to the cooling blocks, one cooling block at a time. Also, because of soldering in vacuum, the soldered metal (solder or the like) is not oxidized.

A water channel 22a is formed in the inlet manifold 22, and the water channel 22a communicates with an inlet of the cooling block water channel 21. Cooling water flows into the inlet manifold water channel 22a via an inlet nozzle 24. A water channel 23a is formed in the outlet manifold 23, and the water channel 23a communicates with an outlet of the cooling block water channel 21. Cooling water flowing through the outlet manifold water channel 23a is discharged via an outlet nozzle 25.

The water channel sectional area of the inlet manifold water channel 22a is not less than twice the water channel sectional area of the cooling block water channel 21 (a total of the water channel sectional areas of three of the cooling block water channels). The outlet manifold water channel 23a has the same water channel sectional area as that of the inlet manifold water channel 22a. When the water channel sectional area of the inlet manifold water channel 22a is rendered twice the water channel sectional area of the cooling block water channel 21, changes in the velocity of cooling water flowing through the cooling block water channel 21 are decreased to 1/4, compared with the water channel sectional area of the inlet manifold water channel 22a being the same as the water channel sectional area of the cooling block water channel 21.

In detail, a flow velocity distribution occurs in proportion to the square of the flow velocity. Thus, if the flow velocity of cooling water flowing through the inlet manifold water channel 22a is high, a noticeable flow velocity distribution occurs in the inlet manifold water channel 22a. This flow velocity distribution appears, unchanged, as the flow velocity distribution of cooling water flowing through the three cooling block water channels 21. As a result, variations occur in the heat elimination of the LD device 18, leading to fluctuations in the output of laser light. Hence, the water channel sectional area of the inlet manifold water channel 22a is rendered not less than twice the water channel sectional area of the cooling block water channel 21, thereby decreasing the flow velocity of the inlet manifold water channel 22a. By this measure, the flow velocity distribution of the inlet manifold water channel 22a is curtailed (brought close to a uniform flow velocity) to curb the flow velocity distribution of the three cooling block water channels 21. When changes in the velocity of cooling water in the cooling block water channels 21 are decreased in this manner, fluctuations in the output of laser light dependent on the changes in the velocity of cooling water are diminished.

Thus, the conventional approach zone (see FIGS. 10(a), 10(b)) is unnecessary for the cooling block water channel 21. As a result, the length L₂ of the cooling block 17 shown in FIG. 2(b) is, for example, 16 mm, by far a shorter length than the conventional cooling block. The length L₁ of the LD device 18 shown in FIG. 2(b) is 10 mm as described earlier.

As shown in FIG. 3(a), an inlet portion 21a of the cooling block water channel 21 may be chamfered over the entire periphery. Alternatively, as shown in FIG. 3(b), the inlet portion 21a of the cooling block water channel 21 may be given a curvature on the entire periphery. By so doing, the pressure loss coefficient of cooling water can be halved or reduced more greatly. In this case, moreover, an increase in pressure loss due to an abrupt reduction of the water channel sectional area can be curtailed.

Furthermore, as shown in FIGS. 3(a) and 3(b), an inner peripheral surface 21b on the outlet side of the cooling block water channel 21 is desirably formed as a tapered surface having an inclination angle θ of up to 7 degrees, as generally known in hydrodynamics. This is intended to prevent cooling water from falling off the inner peripheral surface 21b, thereby stabilizing the flow status of cooling water flowing out of the cooling block water channel 21 into the outlet manifold water channel 23a.

Besides, as shown in FIGS. 4(a) and 4(b), the LD device 18 has an anode surface 18a intimately fixed to a side surface 17c of the cooling block 17 by bonding means, such as soldering (a soldering portion 28). The intimate contact of the LD device 18 with the cooling block 17 is designed to transfer heat generated by the LD device 18 to the cooling block 17 evenly without fail. The reason for the bonding of the anode surface 18a of the LD device 18 to the cooling block 17 is that the position of emission of laser light 19 is in the vicinity of the anode surface 18a, and heat generation occurs at this position. If a cathode surface 18b of the LD device 18 is bonded to the cooling block 17, the position of heat generation becomes remote from the cooling block 17, making heat elimination difficult. In addition, heat generated on the anode side is transmitted to the cooling block 17 via the cathode side, thus causing a temperature distribution in the LD device.

A thin submount plate 29 of copper is bonded, as an LD device hold-down, to the anode surface 18b of the LD device 18. One of the surfaces, 29a, of the submount plate 29, and the anode surface 18b of the LD device 18 are bonded together by bonding means such as soldering. To the other surface 29b of the submount plate 29, an electrode plate 27 of copper is bonded. The cooling block 17 and the inlet and outlet manifolds 22 and 23 are also made of copper.

The electrode plate 27 is fixed to the cooling block 17 by an electrical insulating screw (not shown) via an electrical insulating sheet 30. The reason why the submount plate 29 is located between the electrode plate 27 and the LD device 18 is that by so doing, an excessive load is not imposed on the LD device 18 when the electrode plate 27 is screwed to the cooling block 17.

The three water channels 21 are formed in the cooling block 17 so as to be located near the LD device 18 fixed to the side surface 17c. The number of the cooling block water channels 21 can be set, as desired, according to the amount of heat elimination or the like.

Furthermore, the three cooling block water channels 21 are formed with constant spacing relative to each other, have water channel sections (cross sections) equally in the form of an elongated hole, and slant at an angle of 45° to the side surface 17c of the cooling block. The cooling block water channel 21 has a very small width d₂ (e.g., 0.2 mm) of the water channel section, and is formed by wire cutting or the like. The length L₃ of the cross section of the cooling block water channel 21 is set, for example, at 2.8 mm. The reason why the water channel sectional shapes of the three cooling block water channels 21 are the same is that by so doing, the pressure loss coefficients of these water channels 21 are equalized to uniformize the flow velocities of cooling water flowing through these water channels 21, thereby eliminating the heat of the LD device 18 evenly.

The three cooling block water channels 21 formed in the above-mentioned manner have a structure like radiation fins for the LD device 18. Heat generated by the LD device 18 is transferred to cooling water, which flows through the cooling block water channels 21, via portions 17a between the cooling block water channels 21 and so on.

Thus, compared with the earlier technologies, the water channel surface area close to the LD device increases, making the heat transfer area very large and the heat flux on the water channel surface near the LD device very small. Consequently, cooling performance markedly improves. Also, the pressure loss coefficient of cooling water can be decreased by making the water channel sectional shape of the cooling block water channel 21 an elongated hole. Moreover, the cooling block water channels 21 are inclined with respect to the cooling block side surface 17c, so that the width d₃ of the cooling block 17 can be decreased.

In short, forming the cooling block water channel 21 into the above-described elongated hole/inclined type realizes, at the same time, the restriction of the width d₃ of the cooling block 17 to a predetermined value (e.g., 3 mm) for increasing the integration density of the LD devices 18, and the elongation of the water channel section of the cooling block water channel 21 for ensuring a sufficient heat transfer area and reducing the pressure loss coefficient.

To increase the heat transfer area further, irregularities 31 may be formed on the inner surface of the cooling block water channel 21, as shown in FIG. 5. Such irregularities 31 can be formed, for example, by performing wire electric discharge machining while shaking a wire. By forming the irregularities 31 on the inner surface of the cooling block water channel 21, the heat transfer area increases, for example, 1.4-fold, so that the heat flux further decreases.

The water channel sectional shape of the cooling block water channel 21 is not necessarily limited to the elongated hole/inclined type, but is considered to be a shape, for example, as shown in FIG. 6, 7 or 8.

In FIG. 6, the water channel sectional shape of the cooling block water channel 21 is perpendicular to the cooling block side surface 17c. In this case, however, the width d₃ of the cooling block 17 increases as stated above, inducing the upsizing of the apparatus and a decrease in the integration density of the LD devices. To solve these problems, the cooling block water channel 21 is of the inclined type in the aforementioned descriptions.

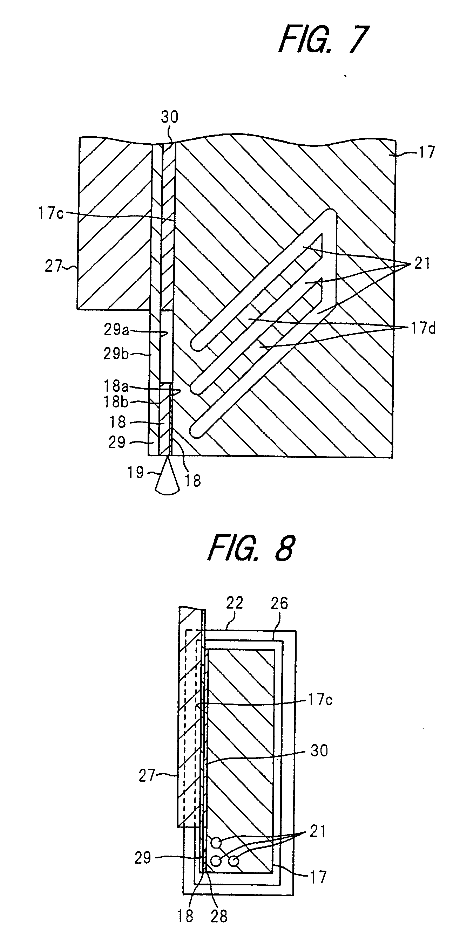

In FIG. 7, right end portions of the three cooling block water channels 21 are coupled together. In this case, however, the portions 17d between the cooling block water channels 21 cantilever. Thus, the portions 17d have low rigidity, and vibrate in the presence of cooling water. Formation of such a structure by processing is also difficult. On the other hand, when the three cooling block water channels 21 are independent of each other as shown in FIGS. 4(a) and 4(b), opposite end portions of the portions 17d between the cooling block water channels 21 are supported by the cooling block body. Thus, the rigidity of the portions 17d is improved, and their vibrations due to cooling water can be suppressed. Also, processing into the independent-type structure is easy.

In FIG. 8, the water channel sectional shape of the cooling block water channel 21 is circular. In this case, however, the pressure loss coefficient increases, making it difficult to secure a desired amount of cooling water. To solve this problem, the cooling block water channel 21 is in the form of an elongated hole in the aforementioned descriptions.

FIG. 9 shows the cooling blocks 17 in a stacked condition. As shown in the drawing, a multiplicity (e.g., 25) of the cooling blocks 17, each having the LD device 18 fixed thereto, are stacked to constitute the LD apparatus 13. A drive current is flowed by a power source device (not shown) in the stack direction (vertical direction in the drawing) of the cooling blocks 17, whereby laser light 17 is emitted from the respective LD devices 18. The laser light 17 is incident on the slab-shaped YAG crystal 12 to emit YAG laser light 20 (see FIG. 1).

The flow of the drive current will be described in detail with reference to FIGS. 4(a), 4(b) and FIG. 9. The drive current supplied from the power source device (not shown) is introduced from the electrode plate 27 on the cooling block 17 on one end side of the stack, and flowed through the submount plate 29, LD device 18, cooling block 17, and inlet and outlet manifolds 22 and 23 in this order. Then, the drive current is introduced into the electrode plate 27 on the adjacent cooling block 17, then flowed in the same manner eventually into the inlet and outlet manifolds 22 and 23 of the cooling block 17 on the other end side of the stack, and returned to the power source device. In this case, the method of electrically connecting the inlet and outlet manifolds 22 and 23 of the cooling block 17 to the electrode plate 27 on the adjacent cooling block 17 may be by a structure in which these members overlap and electrically contact, or by connection using an electric cable. Alternatively, the cooling block 17 and the electrode plate 27 on the adjacent cooling block 17 may be directly electrically connected, rather than via the inlet and outlet manifolds 22 and 23.

The respective cooling channels are independent of each other. Thus, if any of the LD devices 18 in the stack is damaged, for example, only the cooling block 17 having the damaged LD device 18 fixed thereto may be detached, and replaced by a new cooling block 17.

As FIG. 9 shows the cooling system, cooling water fed from a temperature controlled cooling water circulator (not shown) is separated into streams entering the respective inlet manifolds 22, flowed through the water channels 21 of the respective cooling blocks 17, then discharged to the respective outlet manifolds 23, then merged again, and returned to the temperature controlled cooling water circulator.

According to the present embodiment, as described above, the cooling block 17 has the three water channels 21 formed so as to be located near the LD device 18 fixed to the side surface 17c, and is adapted to eliminate generated heat of the LD device 18 by cooling water flowing through these water channels 21. Thus, the water channel surface (heat transfer area) close to the LD device markedly increases compared with the earlier technologies, resulting in a decreased heat flux. Thus, the cooling block 17 can be applied as a heat sink for a high output/continuous wave oscillation LD apparatus.

Moreover, the three cooling block water channels 21 are each of an elongated hole/inclined type whose water channel section is in the shape of an elongated hole and which is inclined relative to the cooling block side surface 17c. Thus, a sufficient heat transfer area can be secured, the pressure loss coefficient can be decreased, and the width d₃ of the cooling block 17 can be narrowed. Hence, when many of the cooling blocks 17, each having the LD device 18 fixed thereto, are stacked to constitute the LD apparatus 13, the LD devices 18 can be integrated at a high density, and the apparatus can be downsized.

Furthermore, the formation of the irregularities 31 on the inner surface of the cooling bloc water channel 21 can further increase the heat transfer area and decrease the heat flux, thus further increasing the heat elimination capacity.

Besides, the water channel sectional area of the inlet manifold 22 attached to the inlet side of the cooling block water channel 21 is rendered not less than twice the water channel sectional area of the cooling block water channel 21, thereby decreasing changes in the velocity of cooling water flowing through the cooling block water channel 21. Thus, the conventional approach zone is unnecessary for the cooling block water channel 21. As a result, the cooling block 17 can be made much shorter than the conventional cooling block. Hence, the cooling block 17 is suitable for making the water channel section tiny, and contributes to downsizing of the apparatus.

In addition, the inlet portion 21a of the cooling block water channel 21 is chamfered or given a curvature, whereby the pressure loss coefficient of cooling water can be reduced. Thus, it is possible to obtain the desired amount (flow velocity) of cooling water easily, and curtail an increase in pressure loss due to an abrupt reduction of the water channel sectional area between the inlet manifold water channel 22a and the cooling block water channel 21.

The LD apparatus 13 having the above-described cooling blocks 17 is a high performance apparatus excellent in oscillation efficiency, small in size, and capable of high output/continuous wave oscillation. The YAG laser apparatus 11 having the LD apparatuses 13 as an exciting light source is also a high performance apparatus compact and capable of high output/continuous wave oscillation.

### Industrial Applicability

As described above, the cooling block of the present invention, the LD apparatus having the cooling blocks, and the solid state laser apparatus having the LD apparatuses as an exciting light source have a high capacity to eliminate heat, are applicable to a high output/continuous wave oscillation LD apparatus, and are so small in dimensions as to be suitable for making the water channel section tiny.

## Claims

1. A cooling block **characterized in that** a plurality of refrigerant channels are formed so as to be located near an LD device fixed to a side surface of the cooling block, and heat generated by the LD device is eliminated by a refrigerant flowing through the refrigerant channels.

2. The cooling block of claim 1, **characterized in that**
the plurality of refrigerant channels each have a channel sectional shape like an elongated hole, and are inclined relative to the side surface.

3. The cooling block of claim 1 or 2, **characterized in that**
irregularities are formed on an inner surface of each of the refrigerant channels.

4. The cooling block of claim 1, 2 or 3, **characterized in that**
a channel sectional area of an inlet manifold attached to an inlet side of the refrigerant channel is rendered not less than twice a channel sectional area of the refrigerant channel.

5. The cooling block of any one of claims 1, 2, 3 and 4, **characterized in that**
an inlet portion of the refrigerant channel is chamfered or given a curvature.

6. An LD apparatus comprising the cooling block of any one of claims 1, 2, 3, 4 and 5 having the LD device fixed to the side surface of the cooling block.

7. An LD apparatus comprising a stack of a plurality of the cooling blocks of claim 1, 2, 3, 4 or 5, each of the cooling blocks having the LD device fixed to the side surface thereof.

8. A solid state laser apparatus having the LD apparatus of claim 6 or 7 as an exciting light source, and adapted to direct laser light emitted from the LD apparatus at a solid crystal.
